# EUROPÄISCHE PATENTSCHRIFT

(11) **EP 1 818 982 B1**
(45) Veröffentlichungstag und Bekanntmachung des Hinweises auf die Patenterteilung: **01.01.2014**
(21) Anmeldenummer: 07002032.6
(22) Anmeldetag: 31.01.2007
(51) Int. Cl.: H01L 23/48

(54) **Anordnung mit mindestens einem Leistungshalbleitermodul und einem Kühlbauteil und zugehöriges Herstellungsverfahren**
Assembly of at least one power semiconductor module and a cooling element and associated method of manufacturing
Assemblage avec au moins un module semi-conducteur de puissance et un élément de refroidissement et méthode de fabrication associée

(30) Priorität: 13.02.2006 DE 102006006424
(43) Veröffentlichungstag der Anmeldung: 15.08.2007
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- DE-A1- 4 237 632
- DE-C1- 10 127 947
- DE-C1- 19 617 055
- US-A1- 2002 027 283

## Beschreibung

Die Erfindung beschreibt eine Anordnung mit mindestens einem Leistungshalbleitermodul in Druckkontaktausführung und mit einem Kühlbauteil sowie ein zugehöriges Herstellungsverfahren. Einen Ausgangspunkt der Erfindung bilden Leistungshalbleitermodule wie sie beispielhaft aus der DE 197 19 703 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind Druck kontaktierte Leistungshalbleitermodule, wie sie aus der DE 42 37 632 A1, der DE 199 03 875 A1 oder der DE 101 27 947 C1 bekannt sind. Bei erstgenannter Druckschrift weist die Druckeinrichtung ein stabiles, vorzugsweise metallisches, Druckelement zum Druckaufbau, ein elastisches Kissenelement zur Druck Speicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgeht.

Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.

Die DE 199 03 875 A1 bildet das bekannte Druckelement derart weiter, dass es einerseits ein besonders vorteilhaftes Verhältnis aus Gewicht und Stabilität aufweist und andererseits elektrisch isolierte Durchführungen aufweist. Hierzu ist das Druckelement als ein Kunststoffformkörper mit innen liegender Metallseele ausgebildet. Diese Metallseele weist Ausnehmungen für die Durchführung von Anschlusselementen, vorzugsweise Hilfsanschlusselementen in Federkontaktausführung, auf. Der Kunststoffformkörper umschließt diese Ausnehmungen derart, dass die Hilfsanschlusselemente mittels des Kunststoffformkörpers elektrisch von der Metallseele isoliert sind.

Es sind auch weitergebildete Druckelemente bekannt, die an ihrer dem Substrat zugewandten Oberfläche eine Vielzahl von Druckfingern aufweisen. Vorzugsweise weist hierbei die Metallseele noch eine voreingestellte Durchbiegung auf. In der Kombination beider Maßnahmen kann ein derartiges Druckelement die gesamte Funktionalität einer oben genannten Druckeinrichtung bereitstellen.

Aus der DE 101 27 947 C1 ist ein Leistungshalbleitermodul bekannt, wobei die Lastanschlusselemente derart ausgebildet sind, dass sie in Abschnitten eng benachbart senkrecht zur Substratoberfläche verlaufen und von dort ausgehende Kontaktfüße aufweisen, die den elektrischen Kontakt zu den Leiterbahnen herstellen und gleichzeitig Druck auf das Substrat ausüben und somit dessen thermischen Kontakt zu einem Kühlbauteil herstellen. Der Druck wird hierbei mit Mitteln nach dem Stand der Technik eingeleitet und gespeichert.

Aus der DE 10 2004 021 927 A1 ist ein Verfahren zur inneren Isolation von Leistungshalbleitermodulen bekannt, wobei diese im Gegensatz zum vorbekannten Stand der Technik nicht bis zu einer definierten Füllhöhe mit einem isolierenden Silikongel verfüllt sind. Im Gegensatz dazu wird hier ein Verfahren zur Beschichtung der zu isolierenden Bauteile und Verbindungselemente vorgestellt, welches eine erhebliche Menge an Silikongel einspart.

Die US 2002/0027283 A1 offenbart eine Anordnung eines Leistungshalbleiter moduls auf einem Kühlbauteil.

Die DE 196 17 055 C1 offenbart ein Leistungshalbleitermodul mit internen Schaltungsversbrahtungen.

Der Erfindung liegt die Aufgabe zugrunde eine Anordnung und ein zugehöriges Herstellungsverfahren für diese Anordnung mit mindestens einem Leistungshalbleitermodul in Druckkontaktausführung vorzustellen, wobei eine beliebige auch thermische Ausdehnungen des Substrats nicht auf das Gehäuse des Leistungshalbleitermoduls übertragen wird.

Die Aufgabe wird erfindungsgemäß gelöst, durch die Maßnahmen der Merkmale der Ansprüche 1 und 7. Bevorzugte Ausführungsformen sind in den Unteransprüchen beschrieben.

Der erfinderische Gedanke geht aus von einer Anordnung eines Leistungshalbleitermoduls in Druckkontaktausführung auf einem Kühlbauteil mit mindestens einem Substrat, mindestens zwei hierauf angeordneten steuerbaren Leistungshalbleiterbauelementen, beispielhaft bipolaren Transistoren, einem Gehäuse und nach außen führenden Last- und Steueranschlusselementen. Das Substrat selbst weist einen Isolierstoffkörper auf und auf dessen erster, dem Inneren des Leistungshalbleitermoduls zugewandten Hauptfläche Leiterbahnen mit Lastpotential. Weiterhin weist das Substrat vorzugsweise auch mindestens eine Leiterbahn mit Steuerpotential zu Ansteuerung der Leistungshalbleiterbauelemente auf.

Das Leistungshalbleitermodul weist weiterhin Lastanschlusselemente jeweils ausgebildet als Metallformkörper mit einem bandartigen Abschnitt und mit einer Mehrzahl von diesem ausgehenden Kontaktfüßen auf. Die jeweiligen bandartige Abschnitte sind parallel zur Substratoberfläche und von dieser beabstandet angeordnet. Die Kontaktfüße, die von dem bandartigen Abschnitt ausgehen reichen zum Substrat und bilden dort schaltungsgerecht die Kontakte der Lastanschlüsse aus. Vorzugsweise kontaktieren sie hierzu auf dem Substrat die Leiterbahnen mit Lastpotential, alternativ auch direkt die Leistungshalbleiterbauelemente.

Weiterhin kann zwischen den bandartigen Abschnitt der Lastanschlusselemente, die hierbei vorzugsweise einen Stapel ausbilden, und dem Substrat ein Isolierstoffformkörper angeordnet sein. Dieser Isolierstoffformkörper weist Ausnehmungen zur Durchführung der Kontaktfüße auf. Der Isolierstoffformkörper bildet hierbei vorzugsweise eine vollständig geschlossene Fläche aus, die ausschließlich Ausnehmungen für elektrische Anschlusselemente aufweist. Es kann weiterhin bevorzugt sein, wenn der Isolierstoffformkörper noch Ausnehmungen für Befestigungseinrichtungen des Leistungshalbleitermoduls auf dem Kühlbauteil aufweist.

Das Gehäuse des Leistungshalbleitermoduls ist erfindungsgemäß fest mit dem Kühlbauteil verbunden. Ebenso ist die Druckplatte mechanisch fest mit dem Gehäuse verbunden. Somit bilden das Kühlbauteil, das Gehäuse und die Druckplatte eine erste Einheit der Anordnung aus. Das mindestens eine Substrat ist derart in dem rahmenartigen Gehäuse angeordnet, dass es sich beispielhaft durch thermische Einflüsse in engen Grenzen darin bewegen kann. Ebenso wenig weisen die Last- und Hilfsanschlusselemente starre Verbindungen mit dem Gehäuse auf. Diese können sich in allen Führungen gegenüber dem Gehäuse bewegen. Da die Druckeinleitung mittels des elastischen Druckspeichers erfolgt ist auch hier keine starre Verbindung gegeben. Somit ist die erste Einheit erfindungsgemäß von der zweiten Einheit gebildet aus dem mindestens einen Substrat und den Last- und Hilfsanschlusselementen mechanisch entkoppelt.

Die Bewegungsfreiheit der zweiten innerhalb der ersten Einheit der erfinderischen Anordnung aus mindestens eine Leistungshalbleitermodul auf einem Kühlbauteil weist den wesentlichen Vorteil auf, dass beispielhaft durch thermische Einflüsse eingeprägte Bewegungen des Substrats nicht auf das Gehäuse des Leistungshalbleitermoduls übertragen werden.

Das zugehörige Verfahren zur Herstellung einer oben genannten Anordnung weist die folgenden wesentlichen Schritte auf:
- Anordnen der Lastanschlusselemente mit geeigneter elektrischer Isolierung gegeneinander im Gehäuse des Leistungshalbleitermoduls.
- Anordnen des Druckspeichers oberhalb der Lastanschlusselemente.
- Vorläufige Arretierung der Druckplatte auf dem Druckspeicher an oder im Gehäuse.
- Anordnen mindestens eines mittels einer Isolierstoffmasse elektrisch isolierten Substrats mit hierauf angeordneten und schaltungsgerecht verbundenen Leistungshalbleiterbauelementen in einer zugeordneten Ausnehmung des Gehäuses, wobei die Isolierstoffmasse eine haftenden Verbindung zwischen dem Substrat und dem Gehäuse bildet.
- Anordnen mindestens eines Leistungshalbleitermoduls auf dem Kühlbauteil und Befestigung dessen Gehäuses auf dem Kühlbauteil.
- Druckeinleitung auf das Leistungshalbleitermodul über den Druckspeicher auf die Lastanschlusselemente und deren Kontaktfüße auf das mindestens eine Substrat zu dessen thermischen Kontaktierung mit dem Kühlbauteil durch Verschrauben der Druckplatte mit dem Gehäuse und / oder dem Kühlbauteil.

Die Hilfsanschlusselemente werden zwischen zwei beliebigen Schritten vor Anordnung der Druckplatte in dafür vorgesehenen Führungen angeordnet. Weiterhin kann es besonders bevorzugt sein eine vorläufige Arretierung der Druckplatte auf dem Druckspeicher im Gehäuse mittels einer Schnapp- Rast- Verbindung zwischen der Druckplatte und dem Gehäuse auszuführen. Ebenso bevorzugt ist es die Isolierstoffmasse zuerst raupenartig um die Randbereiche des jeweiligen Substrats aufzubringen und anschließend den im Inneren der Raupe liegende Bereich zu vergießen.

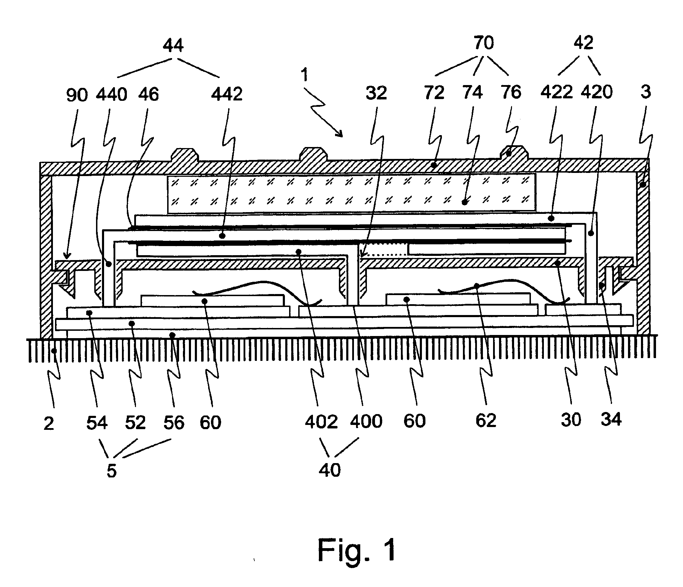

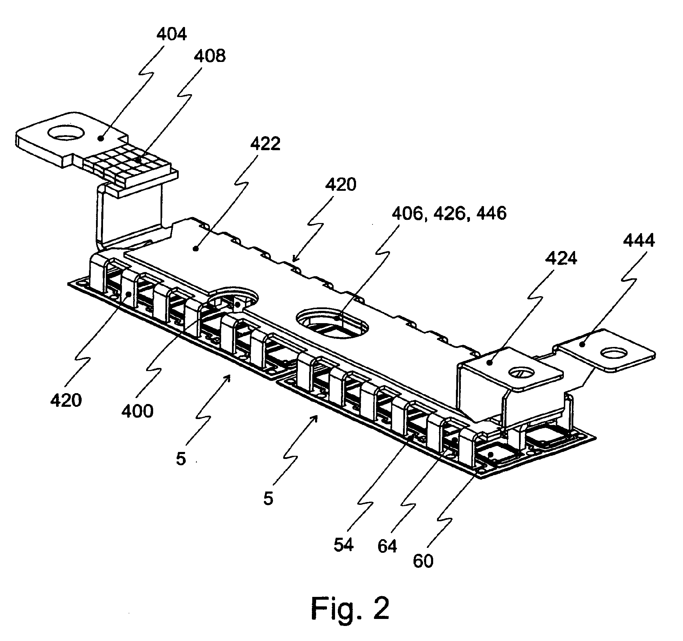

Die erfinderische Lösung wird an Hand der Ausführungsbeispiele der Fig. 1 und 2 weiter erläutert.

Fig. 1 zeigt einen Schnitt durch eine erfindungsgemäße Anordnung eines Leistungshalbleitermoduls mit einem Kühlbauteil.

Fig. 2 zeigt in dreidimensionaler Darstellung einen Schnitt durch eine zweite Einheit einer erfindungsgemäßen Anordnung.

Fig. 1 zeigt einen Schnitt durch eine Anordnung eines Leistungshalbleitermoduls (1). Dieses weist ein Gehäuse (3) mit einen rahmenartigen Gehäuseteil auf, der fest mit dem Kühlbauteil (2) der Anordnung verbunden ist. Der rahmenartige Gehäuseteil umschließt hierbei das mindestens eine Substrat (5). Dieses wiederum weist einen Isolierstoffkörper (52), vorzugsweise eine Isolierkeramik, wie Aluminiumoxid oder Aluminiumnitrit auf.

Auf der, dem Inneren des Leistungshalbleitermoduls (1) zugewandten, ersten Hauptfläche weist das Substrat (5) eine in sich strukturierte Metallkaschierung auf. Die einzelnen Abschnitte dieser vorzugsweise als Kupferkaschierung ausgestalteten Metallkaschierung bilden hierbei die Leiterbahnen (54) des Leistungshalbleitermoduls (1) aus. Die zweite Hauptfläche des Substrats (5) weist gemäß dem Stand der Technik eine nicht strukturierte Kupferkaschierung (58) auf.

Auf den Leiterbahnen (54) des Substrats (5) sind steuerbare und / oder ungesteuerte Leistungshalbleiterbauelemente (60) wie beispielhaft IGBTs (insulated gate bipolar Transistor) mit jeweils antiparallel geschalteten Freilaufdioden, oder MOS-FETs angeordnet. Diese sind schaltungsgerecht mit weiteren Leiterbahnen (54), beispielhaft mittels Drahtbondverbindungen (62), verbunden.

Die Lastanschlusselemente (40, 42, 44) mit den verschiedenen notwendigen Potentialen dienen der externen Verbindung der leistungselektronischen Schaltung im Inneren des Leistungshalbleitermoduls (1). Hierzu sind die Lastanschlusselemente (40, 42, 44) als Metallformkörper ausgebildet, die je einen bandartigen Abschnitt (402, 422, 442) parallel zur Substratoberfläche aufweisen. Die bandartigen Abschnitte (402, 422, 442) bilden hierbei einen Stapel, wobei die bandartigen Abschnitte der einzelnen Lastanschlusselemente (40, 42, 44) ausschließlich durch eine notwendige Isolierung, beispielhaft in Form einer Kunststofffolie (46), voneinander beabstandet sind. Notwendige Hilfsanschlusselemente sind aus Gründen der Übersichtlichkeit in dieser Schnittzeichnung nicht dargestellt.

Vorzugsweise weist das erfindungsgemäße Leistungshalbleitermodul (1) eine als Isolierstoffformkörper (30) ausgebildete Zwischenlage zwischen dem Stapel der bandartigen Abschnitte (402, 422, 442) der Lastanschlusselemente (40, 42, 44) und dem Substrat (5) auf. Dieser Isolierstoffformkörper (30) ist in dieser Ausgestaltung in dem rahmenartigen Gehäuse (3) mittels einer Schnapp- Rast- Verbindung (90) angeordnet.

Der Isolierstoffformkörper (30) weist seinerseits Ausnehmungen (32) zur Durchführung der Kontaktfüße (400, 420, 440) der Lastanschlusselemente (40, 42, 44) auf. Es ist besonders bevorzugt, wenn diese Ausnehmungen (32) als Führungen für diese Kontaktfüße (400, 420, 440) ausgebildet sind, wodurch die Positionierung der Lastanschlusselemente (40, 42, 44) relativ zum Substrat (5) bzw. dessen Leiterbahnen (54) nochmals gegenüber einer Anordnung mit einfachen Ausnehmungen verbessert wird. Erfindungsgemäß weisen diese Ausnehmungen (32) in jeglicher lateraler Richtung eine Breite auf, die geeignet ist eine Führung der Kontaktfüße (400, 420, 440) sicherzustellen und andererseits deren laterale Bewegung bis zu mindestens 0,2mm, vorzugsweise bis zu 0,3mm, zu gewährleisten.

Die Druckeinrichtung (70) zur thermischen Verbindung des Leistungshalbleitermoduls (1) mit einem Kühlbauteil (2) und gleichzeitig zur elektrischen Kontaktierung der Lastanschlusselemente (40, 42, 44) mit den Leiterbahnen (54) des Substrats (5) wird gebildet durch ein Druckelement (72) zum Druckaufbau sowie, ein elastisches Kissenelement als Druckspeicher (74). Der Druck wird über das Kissenelement (74) auf den Stapel aus den bandartigen Abschnitten (402, 422, 442) der Lastanschlusselemente (40, 42, 44) eingeleitet und übt somit Druck auf die Kontaktfüße (400, 420, 440) aus. Hierdurch werden diese elektrisch leitend mit Leiterbahnen (54) des Substrats (5) verbunden.

Derartige Druckkontaktierungen (70) haben sich über die Lebensdauer von Leistungshalbleitermodulen (1) als besonders kontaktsicher erwiesen. Weiterhin vorteilhaft für die Druckkontaktierung ist die Ausbildung der Ausnehmungen (32) des Isolierstoffformkörpers (32) als Führungen bzw. Schächte (34), da hierdurch die Positionierung der Kontaktfüße (400, 420, 440) besonders genau ist.

Das Druckelement (72) kann gemäß dem Stand der Technik als Kunststoffformkörper mit geeigneter, beispielhaft als Bimetall ausgebildeter, innen liegender Metallseele und äußeren Versteifungsstrukturen (76) ausgeführt sein. Es ist weiterhin bevorzugt, wenn das Druckelement (72) gleichzeitig als Deckel des Leistungshalbleitermoduls (1) dient.

Die erste Einheit der Anordnung wird hier gebildet durch das Kühlbauteil (2), das Gehäuse (3) und das Druckelement (72). Die Teile dieser Einheit sind fest miteinander verbundenen. Die zweite Einheit wird hier gebildet aus dem Substrat (5) mit den schaltungsgerecht verbundenen Leistungshalbleiterbauelementen (60) und den Lastanschlusselementen (40, 42, 44). Die beiden Einheiten weisen keine mechanisch starre Verbindung zueinander auf, vielmehr kann die zweite Einheit sich in jede laterale Richtung mindestens 0,2mm, vorzugsweise 0,3mm, innerhalb der ersten Einheit bewegen.

Fig. 2 zeigt in dreidimensionaler Darstellung einen Schritt durch eine zweite Einheit einer erfindungsgemäßen Anordnung. Diese weist zwei Substrate (5) mit hierauf angeordneten und schaltungsgerecht mittels nicht dargestellter Bondverbindungen verbunden Leistungshalbleiterbauelementen (60, 64) auf. Die dargestellte Schaltung ist eine Halbbrückenschaltung mit einer Mehrzahl die jeweiligen ersten und zweiten Schalter bildenden parallel geschalteten bipolaren Transistoren (60, 64). Ebenfalls weist die Schaltung die notwendigen Freilaufdioden (64) auf. Die ersten und zweiten Schalter der Halbbrückenschaltung sind hierbei jeweils hälftig auf zwei identische Substrate (5) verteilt.

Die Lastanschlusselemente (40, 42, 44) dieser zweiten Einheit einer erfindungsgemäßen Anordnung und deren Position zu den Substraten (5) ist ebenfalls dargestellt. Aus Gründen der Übersichtlichkeit sind die isolierenden Kunststofffolien zwischen den einzelnen Lastanschlusselementen (40, 42, 44) nicht dargestellt.

Die Lastanschlusselemente (40, 42, 44) weisen eine Mehrzahl von Kontaktfüßen (400, 420, 440) auf, die von den zugeordneten bandartigen Abschnitten (402, 422, 442) des jeweiligen Lastanschlusselements (40, 42, 44) ausgehen. Jeweils eine Mehrzahl von Kontaktfüßen (400, 420, 440) gleicher Polarität kontaktieren hierbei die zugeordneten Leiterbahnen (54) der jeweiligen Polarität. Die dauerhaft kontaktsichere elektrische Verbindung wird mittels der oben beschriebenen und hier nicht dargestellten Druckeinrichtung (70) ausgebildet.

Dargestellt sind weiterhin Ausnehmung (406, 426, 446) des Stapels aus Lastanschlusselementen (40, 42, 44), die vorgesehen sind für die Anordnung der Hilfsanschlusselemente. Es ist besonders bevorzugt, wenn alle Hilfsanschlusselemente in Längsrichtung des Leistungshalbleitermoduls (1) mittig angeordnet sind. Demgemäß ist es vorteilhaft, wenn alle Hilfsanschlusselemente auf einem Längsabschnitt des Leistungshalbleitermoduls angeordnet sind, der maximal die Halbe Länge des Leistungshalbleitermoduls (1) aufweist. Weiterhin ist es besonders bevorzugt, wenn die Hilfsanschlusselemente als Schraubenfedern ausgebildet sind.

Weiterhin dargestellt ist ein mechanisch flexibler Abschnitt (408) im Verlauf eines Lastanschlusselements, hier des Wechselstromanschlusses (40) des Leistungshalbleitermoduls (1). Dieser flexible Abschnitt (408) ist angeordnet zwischen dem bandartigen Abschnitt (402) oberhalb der Substrate (5) und einer zugeordneten Kontakteinrichtung (404) zur externen elektrischen Verbindung der Anordnung.

Die Ausbildung diese mechanisch flexiblen Abschnitts (408) ist hier als Kupfergewebe, ausgeführt, wie es für flexible Laststromverbindungen außerhalb eines Leistungshalbleitermoduls bekannt ist. Dieses Kupfergewebe ist mit der Kontakteinrichtung (404) und einer Fortsetzung des bandartigen Abschnitts (402) schweißtechnisch verbundenen.

Alternative zu diesem flexiblen Abschnitt (408) wird die laterale Bewegungsfreiheit der zweiten Einheit von mindestens zwei Zehntel Millimeter im Gehäuse mittels geeignete geführter Kontakteinrichtungen (424, 444) der Lastanschlusselemente hier dargestellt der Gleichstromverbindungen (42, 44) erzielt.

## Patentansprüche

1. Anordnung mindestens eines Leistungshalbleitermoduls (1) in Druckkontaktausführung auf einem Kühlbauteil (2), wobei das Leistungshalbleitermodul mindestens ein Substrat (5), mindestens zwei hierauf angeordnete Leistungshalbleiterbauelemente (60, 64), ein Gehäuse (3), nach außen führende Last- (40, 42, 44) und Steueranschlusselemente und eine eine formstabile Druckplatte (72) und einen elastischen Druckspeicher (74) aufweisende Druckeinrichtung (70) aufweist,
wobei das Substrat (5) einen Isolierstoffkörper (52) aufweist und auf dessen erster dem Inneren des Leistungshalbleitermoduls (1) zugewandten Hauptfläche Leiterbahnen (54) mit Lastpotential angeordnet sind und
wobei die Lastanschlusselemente (40, 42, 44) jeweils als Metallformkörper mit einem bandartigen Abschnitt (402, 422, 442) und mit jeweils von diesem ausgehenden Kontaktfüßen (400, 420, 440) ausgebildet sind, der bandartige Abschnitt parallel zur Substratoberfläche und von dieser beabstandet angeordnet sind und die Kontaktfüße (400, 420, 440) von dem bandartigen Abschnitt (402, 422, 442) zu den Leiterbahnen (54) des Substrat (5) reichen und diese kontaktieren, und
wobei das Kühlbauteil (2), das Gehäuse (3) und die Druckplatte (72) eine erste Einheit bilden, die mechanisch entkoppelt ist von der zweiten Einheit gebildet aus Substrat (5) und Lastanschlusselementen (40, 42, 44).

2. Anordnung nach Anspruch 1
wobei Hilfsanschlusselemente in Längsrichtung des Leistungshalbleitermoduls (1) mittig angeordnet sind und der zugeordnete Längsabschnitt des Leistungshalbleitermoduls (1) maximal die Halbe Länge des Leistungshalbleitermoduls (1) aufweist.

3. Anordnung nach Anspruch 1,
wobei die Lastanschlusselemente (40, 42, 44) des Leistungshalbleitermoduls (1) zwischen dem bandartigen Abschnitt (402, 422, 442) oberhalb des Substrats (5) und einer jeweiligen Kontakteinrichtung (404, 424, 444) zur externen Verbindung einen mechanisch flexiblen Abschnitt (408) aufweisen.

4. Anordnung nach Anspruch 3,
wobei der mechanisch flexible Abschnitt (40) als Kupfergewebe ausgebildet ist.

5. Anordnung nach Anspruch 4,
wobei das Kupfergewebe schweißtechnisch mit dem zugeordneten Lastanschlusselement (40, 42, 44) verbundenen ist.

6. Anordnung nach einem der vorgenannten Ansprüche,
wobei das jeweilige Substrat (5) eine laterale Bewegungsfreiheit von mindestens zwei Zehntel Millimeter im Gehäuse (3) aufweist.

7. Verfahren zur Herstellung einer Anordnung nach Anspruch 1
**gekennzeichnet durch** folgende Schritte:
• Anordnen der Lastanschlusselemente (40, 42, 44) mit geeigneter elektrischer Isolierung (46) gegeneinander im Gehäuse (3) des Leistungshalbleitermoduls (1);
• Anordnen des Druckspeichers (74) oberhalb der Lastanschlusselemente (40, 42, 44);
• Vorläufige Arretierung der Druckplatte (72) auf dem Druckspeicher (74) an oder im Gehäuse (3);
• Anordnen mindestens eines mittels einer Isolierstoffmasse elektrisch isolierten Substrats (5) mit hierauf angeordneten und schaltungsgerecht verbundenen Leistungshalbleiterbauelementen (60, 64) in der Ausnehmung des Gehäuses (3), wobei die Isolierstoffmasse eine haftenden Verbindung zwischen dem Substrat (5) und dem Gehäuse (3) bildet;
• Anordnen mindestens eines Leistungshalbleitermoduls (1) auf dem Kühlbauteil (2) und Befestigung des Gehäuses (3)auf dem Kühlbauteil (2);
• Druckeinleitung auf das Leistungshalbleitermodul (1) über die Druckplatte (72) und den Druckspeicher (74) auf die Lastanschlusselemente (40, 42, 44) und deren Kontaktfüße (400, 420, 440) auf das mindestens eine Substrat (5) zu dessen thermischer Kontaktierung mit dem Kühlbauteil (2) **durch** Verschrauben der Druckplatte (72) mit dem Gehäuse (3) und / oder dem Kühlbauteil (2);
Die Hilfsanschlusselemente werden zwischen zwei beliebigen Schritten vor Anordnung der Druckplatte (72) in dafür vorgesehenen Führungen angeordnet.

8. Verfahren nach Anspruch 7
wobei die vorläufige Arretierung der Druckplatte (72) auf dem Druckspeicher (74) im Gehäuse (3) mittels einer Schnapp- Rast- Verbindung zwischen der Druckplatte (72) und dem Gehäuse (3) erfolgt.

9. Verfahren nach Anspruch 7
wobei die Isolierstoffmasse zuerst raupenartig um die Randbereiche des Substrats (5) aufgebracht wird und anschließend der im Inneren der Raupe liegende Bereich vergossen wird.

## Claims

1. An arrangement of at least one power semiconductor module (1) in a pressure-contact design on a cooling component (2), wherein the power semiconductor module has at least one substrate (5), at least two power semiconductor components (60, 64) arranged hereon, a housing (3), outwardly leading load (40, 42, 44) and control connection elements and a pressure apparatus (70) having a dimensionally stable pressure plate (72) and an elastic pressure accumulator (74),
wherein the substrate (5) has an insulant body (52) and conductor tracks (54) with load potential are arranged on the first main surface thereof which faces the interior of the power semiconductor module (1) and wherein the load connection elements (40, 42, 44) are in each case constructed as metal mouldings with a strip-like section (402, 422, 442) and with contact feet (400, 420, 440) emanating therefrom in each case, the strip-like section is arranged parallel to the substrate surface and spaced from the same and the contact feet (400, 420, 440) reach from the strip-like section (402, 422, 442) to the conductor tracks (54) of the substrate (5) and contact the same, and wherein the cooling component (2), the housing (3) and the pressure plate (72) form a first unit which is mechanically decoupled from the second unit made up of substrate (5) and load connection elements (40, 42, 44).

2. The arrangement according to Claim 1,
wherein auxiliary connection elements are arranged centrally in the longitudinal direction of the power semiconductor module (1) and the assigned longitudinal section of the power semiconductor module (1) has a maximum of half the length of the power semiconductor module (1).

3. The arrangement according to Claim 1,
wherein the load connection elements (40, 42, 44) of the power semiconductor module (1) have a mechanically flexible section (408) between the strip-like section (402, 422, 442) above the substrate (5) and a respective contact apparatus (404, 424, 444) for external connection.

4. The arrangement according to Claim 3,
wherein the mechanically flexible section (40) is constructed as a copper fabric.

5. The arrangement according to Claim 4,
wherein the copper fabric is connected to the assigned load connection element (40, 42, 44) by means of welding technology.

6. The arrangement according to one of the previously mentioned claims,
wherein the respective substrate (5) has a lateral freedom of movement of at least two tenths of a millimetre in the housing (3).

7. A method for producing an arrangement according to Claim 1,
**characterised by** the following steps:
• arranging the load connection elements (40, 42, 44) with suitable electrical insulation (46) with respect to one another in the housing (3) of the power semiconductor module (1);
• arranging the pressure accumulator (74) above the load connection elements (40, 42, 44);
• provisional stopping of the pressure plate (72) on the pressure accumulator (74) on or in the housing (3);
• arranging at least one substrate (5), which is insulated by means of an insulating compound, in the recess of the housing (3) with power semiconductor components (60, 64) arranged thereon and connected appropriately for the circuit, wherein the insulating compound forms an adhesive connection between the substrate (5) and the housing (3);
• arranging at least one power semiconductor module (1) on the cooling component (2) and fastening the housing (3) on the cooling component (2);
• introducing pressure onto the power semiconductor module (1) via the pressure plate (72) and the pressure accumulator (74) onto the load connection elements (40, 42, 44) and the contact feet (400, 420, 440) thereof, onto the at least one substrate (5) for the thermal contacting thereof with the cooling component (2) by screwing the pressure plate (72) to the housing thereof (3) and/or the cooling component (2);
The auxiliary connection elements are arranged between any two desired steps before the arrangement of the pressure plate (72) in guides provided therefor.

8. The method according to Claim 7,
wherein the provisional stopping of the pressure plate (72) on the pressure accumulator (74) in the housing (3) by means of a snap-locking connection between the pressure plate (72) and the housing (3).

9. The method according to Claim 7,
wherein the insulating compound is initially applied as a bead around the boundary regions of the substrate (5) and subsequently, the region lying inside the bead is encapsulated.

## Revendications

1. Dispositif avec au moins un module semi-conducteur de puissance (1) en contact de pression sur un composant de refroidissement (2), où le module semi-conducteur de puissance comporte au moins un substrat (5), au moins deux composants semi-conducteurs de puissance (60, 64) disposés sur celui-ci, un boîtier (3), des éléments de connexion de charge (40, 42, 44) et de commande menant vers l'extérieur, une plaque de pression (72) de forme stable et un dispositif de pression (70) pourvu d'un accumulateur de pression (74) élastique,
où le substrat (5) comporte un corps en matériau isolant (52) et des pistes conductrices (54) à potentiel de charge sont disposées sur la première surface principale de ce dernier, opposée à l'intérieur du module semi-conducteur de puissance (1), et
où les éléments de connexion de charge (40, 42, 44) sont réalisés chacun comme corps métallique formé avec une partie en forme de bande (402, 422, 442) et avec des pieds de contact (400, 420, 440) correspondants partant de celle-ci, la partie en forme de bande étant parallèle à la surface du substrat et espacée de celle-ci et les pieds de contact (400, 420, 440) s'étendant de la partie en forme de bande (402, 422, 442) jusqu'aux pistes conductrices (54) du substrat (5) et contactant celles-ci, et
où le composant de refroidissement (2), le boîtier (3) et la plaque de pression (72) forment une première unité mécaniquement désaccouplée de la deuxième unité constituée du substrat (5) et des éléments de connexion de charge (40, 42, 44).

2. Dispositif selon la revendication 1,
où des éléments de connexion auxiliaires sont disposés centralement dans le sens de la longueur du module semi-conducteur de puissance (1) et où la partie de longueur correspondante du module semi-conducteur de puissance (1) est égale au plus à la demi-longueur du module semi-conducteur de puissance (1).

3. Dispositif selon la revendication 1,
où les éléments de connexion de charge (40, 42, 44) du module semi-conducteur de puissance (1) présentent pour le branchement externe une partie mécaniquement flexible (408) entre la partie en forme de bande (402, 422, 442) au-dessus du substrat (5) et un dispositif de contact (404, 424, 444) correspondant.

4. Dispositif selon la revendication 3,
où la partie mécaniquement flexible (40) est réalisée en cuivre tissé.

5. Dispositif selon la revendication 4,
où le cuivre tissé est raccordé par technique de soudage à l'élément de connexion de charge (40, 42, 44) correspondant.

6. Dispositif selon l'une des revendications précédentes,
où chaque substrat (5) présente un jeu de déplacement latéral d'au moins deux dixièmes de millimètre dans le boîtier (3).

7. Procédé de fabrication d'un dispositif selon la revendication 1,
**caractérisé par** les étapes suivantes :
• mise en place l'un contre l'autre des éléments de connexion de charge (40, 42, 44) avec une isolation (46) électrique appropriée dans le boîtier (3) du module semi-conducteur de puissance (1) ;
• mise en place de l'accumulateur de pression (74) audessus des éléments de connexion de charge (40, 42, 44) ;
• fixation provisoire de la plaque de pression (72) sur l'accumulateur de pression (74) contre ou dans le boîtier (3) ;
• mise en place dans la cavité du boîtier (3) d'au moins un substrat (5) isolé électriquement par une masse en matériau isolant avec des composants semi-conducteurs de puissance (60, 64) disposés sur celui-ci et raccordés de manière conforme au circuit, la masse en matériau isolant réalisant une liaison par adhérence entre le substrat (5) et le boîtier (3) ;
• mise en place d'au moins un module semi-conducteur de puissance (1) sur le composant de refroidissement (2) et fixation du boîtier (3) sur le composant de refroidissement (2) ;
• application de pression sur le module semi-conducteur de puissance (1), au moyen de la plaque de pression (72) et de l'accumulateur de pression (74) sur les éléments de connexion de charge (40, 42, 44) et leurs pieds de contact (400, 420, 440) sur le au moins un substrat (5) pour sa ou leur mise en contact thermique avec le composant de refroidissement (2), par vissage de la plaque de pression (72) avec le boîtier (3) et/ou le composant de refroidissement (2) ;
les éléments de connexion auxiliaires étant mis en place entre deux étapes quelconques avant la mise en place de la plaque de pression (72), dans des guidages prévus à cet effet.

8. Procédé selon la revendication 7,
où la fixation provisoire de la plaque de pression (72) sur l'accumulateur de pression (74) dans le boîtier (3) est effectuée au moyen d'une connexion par encliquetage entre la plaque de pression (72) et le boîtier (3).

9. Procédé selon la revendication 7,
où la masse en matériau isolant est appliquée en forme de boudin autour des zones de bord du substrat (5) avant de sceller la zone à l'intérieur du boudin.
